(19) Europäisches Patentamt
European Patent Office
Office européen des brevets

(11) Numéro de publication: 0 011 520
B1

(12) FASCICULE DE BREVET EUROPEEN

(45) Date de publication du fascicule du brevet: 02.06.82

(21) Numéro de dépôt: 79400720.3

(22) Date de dépôt: 08.10.79

(51) Int. Cl.³: C 08 F 20/38, C 08 F 12/30, G 03 C 1/71, C 09 D 3/727 //C07D331/04

# (54) Résine à cycle thiétane réticulable par irradiation électronique ou photonique, et procédé d'utilisation d'une telle résine.

(30) Priorité: 14.11.78 FR 7832109

(43) Date de publication de la demande: 28.05.80 Bulletin 80/11

(45) Mention de la délivrance du brevet: 02.06.82 Bulletin 82/22

(84) Etats contractants désignés: CH DE GB IT NL

(56) Documents cités:

CHEMICAL ABSTRACTS, vol. 70, nr. 13, 31 March 1969, page 339, ref. 57546 g Columbus, Ohio, US NURETDINOVA et al.: Isomerization of thiiranes into thietanes"

CHEMICAL ABSTRACTS, vol. 72, nr. 21, 25 May 1970, page 373, ref. 111179 w Columbus, Ohio, US V. S. ETLIS et al.: "Diene synthesis with sulfur-containing derivatives of acrylic acids"

(73) Titulaire: THOMSON-CSF
173, Boulevard Haussmann
F-75360 Paris Cedex 08 (FR)

(72) Inventeur: Eranian, Armand
THOMSON-CSF - SCPI 173, bld Haussmann
F-75360 Paris Cedex 08 (FR)
Inventeur: Dubois, Jean-Claude
THOMSON-CSF - SCPI 173, bld Haussmann
F-75360 Paris Cedex 08 (FR)
Inventeur: Couttet, André
THOMSON-CSF - SCPI 173, bld Haussmann
F-75360 Paris Cedex 08 (FR)
Inventeur: Datamanti, Evelyne
THOMSON-CSF SCPI 173,bld Haussmann
F75360 Paris Cedex 08 (FR)

(74) Mandataire: Giraud, Pierre et al.
THOMSON-CSF SCPI 173, Bld Haussmann
F-75360 Paris Cedex 08 (FR)

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

EP 0 011 520 B1

# Résine à cycle thiétane réticulable par irradiation électronique ou photonique, et procédé d'utilisation d'une telle résine

L'invention concerne une résine à cycle thiétane réticulable par irradiation électronique ou photonique (rayons gamma, X ou ultraviolets). La synthèse de cette résine ainsi que son utilisation font partie de l'invention.

On connaît le phénomène de réticulation des résines, dites négatives, qui durcissent sous l'effet d'irradiations par l'établissement de liaisons de "pontage" entre les différentes chaînes de polymères qu'elles contiennent, lesdites liaisons entraînant la formation d'un réseau tridimensionnel. Cela se traduit, du point de vue des propriétés intrinsèques des résines, par une augmentation de leur masse moléculaire qui est responsable de leur insolubilité dans des solvants de révélation.

Parmi les résines négatives les plus sensibles, on connaît certaines résines époxy photo-réticulables avec une dose de 1,3 $mJ/cm^2$. D'autre part les publications FR—A—2 352 007 et FR—A—2 382 709 font état de résines negatives, sensibles aux électrons et aux photons, contenant au moins un polymère comprenant un cycle thiirane:

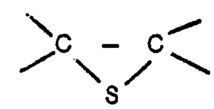

chimiquement lié au polymère, par exemple des copolymères d'un épithiopropylméthacrylate et d'un monomère vinylique.

Ces composés sont environ dix fois plus sensibles que les résines époxy mais présentent le défaut d'être instables notamment sous l'action de la lumière et de la chaleur.

L'invention tend à remédier à cet inconvénient.

La résine selon l'invention comporte au moins un polymère comprenant un cycle thiétane:

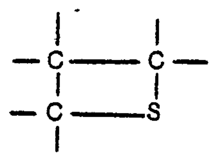

ce cycle faisant partie intégrante de la formule chimique dudit polymère.

Dans une réalisation de l'invention, ledit polymère est un polymère d'un ester méthacrylique de formule générale (1):

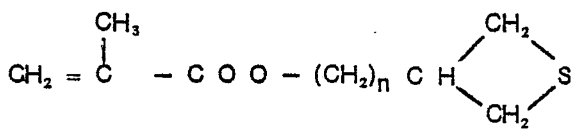

(1)

où n est égal à zero ou à un entier de 1 à 10, de préférence un copolymère d'un premier monomère de formule générale (1) et d'un deuxième monomère de formule générale (2):

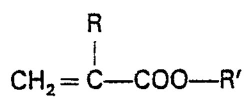

(2)

où R est l'hydrogène ou un groupement alkyle à m atomes de carbone (m entier de 1 à 10) et R' est un groupement alkyle ou un groupement contenant au moins un cycle époxy, oxétane ou thiirane.

Parmi les deuxièmes monomères utilisables, on peut citer le méthacrylate, de méthyle, le méthacrylate de glycidyle, le méthacrylate d'épithio-2,3 propyle, le méthacrylate de butyle et l'acrylate d'éthyle.

L'invention sera mieux comprise au moyen de la description qui suit comportant notamment le procédé général de synthèse de résines selon l'invention, des exemples de modes opératoires et des indications détaillées sur les procédés d'utilisation.

PROCEDE GENERAL DE SYNTHESE:

1°) La synthèse de l'alcool "thiétane" de formule générale (3):

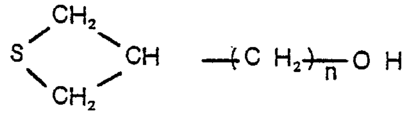

(3)

où n est soit nul, soit un entier de 1 à 10, est effectuée comme suit:

a) dans le cas où n = 0, par action de l'hydrogène sulfuré sur l'épichlorhydrine en milieu alcalin réalisé par exemple à l'aide de baryte;

b) dans le cas où n est différent de zéro, par action de thiocyanate de potassium sur les dioxane-1,3 one — 2 ols — 5 correspondant à la valeur de n.

2°) L'obtention de l'ester méthacrylique de formule générale (1) s'effectue par acylation de l'alcool thiétane de formule (3) par le chlorure de l'acide méthacrylique. La réaction est réalisée à température ambiante en présence de diméthylaniline qui joue le rôle de solvant et sert de piège pour retenir l'acide chlorhydrique formé au cours de la réaction.

3°) La préparation d'un copolymère s'effectue en mélangeant les monomères de formule (1) et (2) dans un solvant qui est par exemple le benzène, puis en faisant agir un catalyseur de polymérisation radicalaire par exemple de l'$\alpha,\alpha'$-azobisisobutyronitrile. Le mélange est ensuite chauffé à 80°C pendant plusieurs heures. Après refoidissement, le copolymère est obtenu par précipitation avec un mélange de méthanol et d'hexane, puis séché sous vide.

4°) En vue de photosensibiliser le copolymère au rayonnement ultra-violet, on peut ajouter au moins l'un des trois sels suivants:

—un sel d'aryldiazonium de formule générale:

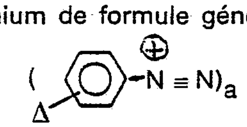 $(M\ X_{b+a})^{a\ominus}$ (4)

—un sel d'aryliodonium:

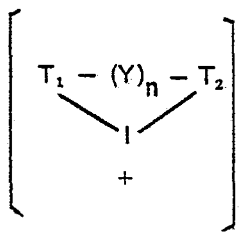 $M\ X_{b+1}^{\ominus}$ (5)

avec n = 0 ou 1.

—un sel de triarylsulfonium:

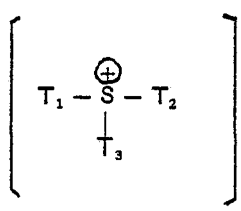 $M\ X_{b+1}^{\ominus}$ (6)

La photolyse de ces sels produit des initiateurs de réticulation cationique.

Dans ces formules:

—le substituant Δ désigne un radical ou une pluralité de radicaux tels que:

OH, $—NH_2$, —CHO, $—NO_2$, $—OCH_3$, 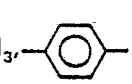 $NO_2$, 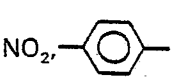 $CH_3$, $—N(CH_3)_2$, $—N(C_2H_5)_2$

—les lettres a et b désignent des entiers de 1 à 5;

—l'élément M est un métal que Fe, Sn, Sb ou Bi ou un autre élément tel que B, P, As;

—X désigne un halogène tel que F ou Cl;

—$T_1$, $T_2$, $T_3$ désignent des radicaux aromatiques (qui peuvent être identiques) comprenant 4 à 20 atomes de carbone (phényle, thiényle, furannyle, pyrazolyle);

—Y désigne un radical tel que:

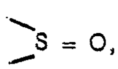, 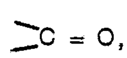, 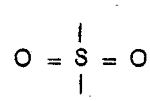

$R_3$—N< (avec $R_3$ = H, un alkyle, ou un acyle);

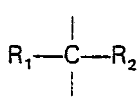

(avec $R_1$ et $R_2$ désignant des radicaux identiques ou différents tels que H ou un alkyle de 1 à 4 atomes de carbone, ou un alkényle de 2 à 4 atomes de carbone.

EXEMPLE DE MODE OPERATOIRE:

Cet exemple est relatif à la synthèse du méthacrylate de 3-thiétanyle de formule (1) avec n = 0 et à la copolymérisation de ce monomère avec le méthacrylate de méthyle en proportion molaire relative de 50%.

La synthèse du méthacrylate de 3-thiétanyle étant réalisée à partir du 3-thiétanol, celui-ci a d'abord été préparé par action de l'hydrogène sulfuré sur l'épichlorhydrine en milieu alcalin, suivant le mode opératoire ci-après:

On met en suspension dans l'eau déminéralisée (0,9 litre) 157,5 g de baryte hydratée (0,5 mole). La solution est agitée et saturée en hydrogène sulfuré. Tout en maintenant le passage de $H_2S$, la masse réactionnelle est refoidie au moyen d'un mélange acétone-carboglace puis on coule 46,26 g d'épichlorhydrine (0,5 mole). Au cours de la coulée (90 mn), la température est maintenue entre 0 et 5°C. Lorsque la coulée est terminée, on arrête le passage de $H_2S$. La masse réactionnelle est alors chauffée pendant une heure à 50—55°C. Après refroidissement à température ambiante, le baryum est précité sous forme de carbonate par passage de gaz carbonique. On sépare alors le carbonate de baryum par filtration. Le produit sur filtre est lavé à l'eau déminéralisée. La phase organique est alors extraite à l'éther de la solution-mère et de l'eau de lavage puis lavée à son tour à l'eau déminéralisée jusqu'à neutralité. Elle est ensuite séchée sur sulfate de sodium. Après avoir chassé l'éther, puis distillé le produit restant, on obtient 19,5 g de 3-thiétanol. La distillation s'effectue à 94—97°C sous 27 mm Hg.

La synthèse du méthacrylate de 3-thiétanyle est alors mise en oeuvre par acylation du 3-thiétanol par le chlorure de méthacryloyle.

Dans une solution de 18 g de 3-thiétanol (0,2 mole) dans la dimethylaniline (80 g soit 0,66 mole) on verse lentement (200 mn) sous agitation 22,99 g de chlorure de méthacryloyle (0,22 mole). L'agitation est ensuite maintenue à température ambiante pendant 8 jours. Après ce délai, la masse réactionnelle est versée sur le mélange suivant: 270 g de glace — 27 $cm^3$ (47,5 g) d'acide sulfurique concentré. La solution est agitée durant 2 heures, puis la phase organique est extraite à l'éther. Elle est ensuite lavée à l'eau déminéralisée jusqu'à neutralité et séchée sur sulfate de sodium. L'éther est chassé puis le produit restant est distillé en présence d'hydroquinone. La température de distillation est de 44°C sous une pression de 0, 1 mm de Hg. On obtient 8,5 g de méthacrylate de 3-thiétanyle.

La synthèse du copolymère de méthacrylate de 3-thiétanyle et de méthacrylate de méthyle (en proportion molaire de 50%) est réalisée comme suit:

On dissout 0,004 g d'$\alpha,\alpha'$-azobisisobutyronitrile dans une solution contenant 2,3 g (0,015 mole) de méthacrylate de 3-thiétanyle et 2,9 g (0,029 mole) de méthacrylate de méthyle préalablement distillé dans 14, 5 $cm^3$ de benzène. La solution est chauffée au reflux de la masse réactionnelle pendant 3 heures et demie. Après refroidissement, elle est coulée dans un mélange de méthanol (76 $cm^3$) et d'hexane (25 $cm^3$): il y a précipitation du copolymère. Le précipité est ensuite lavé au méthanol puis séché sous vide. On obtient 4,7 g de produit sec. Le dosage du soufre, réalisé par analyse élémentaire, a donné le résultat suivant: 8,84 à 9,09% pour 8,94% calculé.

*Utilisation de la résine et exemples d'application:*

Dans ce qui suit, la résine selon l'invention sera désignée par l'appellation "résine thiétane". On peut citer deux cas principaux d'utilisation.

Le premier cas est la fabrication de masques "in situ" au cours d'étapes de réalisation de composants électroniques. C'est la microlithographie utilisée notamment pour la fabrication des circuits intégrés.

Le deuxième cas est le traitement d'objets divers en vue de les revêtir d'une couche protectrice; c'est le cas des gaines de câbles électriques et des articles d'ébénisterie.

Dans les deux cas, on commence par preparer une solution de résine thiétane dans un solvant tel que la méthyl-4 pentanone-2.

Dans le premier cas, on dépose la solution sur un substrat ou sur une plaquette contenant un ou plusieurs circuits, intégrés en cours d'élaboration, en utilisant un dispositif de centrifugation. Suivant la vitesse de rotation du substrat, on obtient une couche d'épaisseur variable, par exemple de 0,5 à 1 micron.

Dans le deuxième cas, on procède soit de la même manière, soit par trempé, soit par pulvérisation. La couche est généralement plus épaisse lorsqu'on utilise cas deux derniers procédés, ce qui est préférable pour obtenir une protection efficace.

Dans les deux cas, on precède ensuite à l'évaporation du solvant de la résine en traitant thermiquement le substrat revêtu de résine, par exemple en le maintenant dans un four à 180°C pendant une demiheure.

On procède ensuite à l'irradiation de la couche de résine. La méthode est choisie en tenant compte de plusieurs facteurs: dimensions de l'objet à irradier, épaisseur de la couche de résine, temps d'irradiation dévolu suivant les sujétions d'ordre industriel.

1°) Si l'on a choisi l'irradiation par les électrons, on peut utiliser par exemple un faisceau d'électrons accélérés sous 20 kV et procéder par balayage de la couche de résine. Le dessin du masque, dans le cas de la microlithographie, est réalisé en programmant le balayage suivant le procédé maintenant classique du masquage électronique.

Le balayage est prolongé un temps suffisant pour produire la réticulation à 70% de la couche de résine.

2°) Si l'on a choisi l'irradiation par rayons ultraviolets, on peut utiliser soit le rayonnement dit "lointain" ($200 < \lambda < 300$ nm) soit le rayonnement dit "proche" ($\lambda > 300$ nm). Dans ce dernier cas il est nécessaire d'ajouter un des photosensibilisateurs décrits ci-avant.

Parmi les sources ultraviolettes utilisables, on peut citer les lampes au deutérium, les lampes à vapeur de mercure, les lasers à molécules organiques.

3°) On peut aussi avoir recours au rayonnement X, en particulier au rayonnement X mou provenant soit du rayonnement synchrotron émis dans un anneau de stockage (spectre continu) soit de l'émission caractéristique de certains éléments, résultant du bombardement d'une cible constituée de ces éléments par des électrons (raies caractéristiques). Les longueurs d'onde pouvant être utilisées dans ce cas sont:

4,6 Å (raie $L_{\alpha1,2}$ du Rh); 5,41 Å (raie $L_{\alpha1,2}$ du Mo); 8,34 Å (raie $K_{\alpha1,2}$ de Al); 13,3 Å (raie $L_{\alpha1,2}$ du Cu); 44,7 Å (raie $K_\alpha$ du C).

4°) On peut enfin avoir recours au rayonnement gamma, émis par exemple par des sources classiques telles que:

$^{137}_{55}Cs$ ($E_\gamma = 0{,}662$ MeV) ou $^{60}_{27}Co$ ($E_{\gamma1} = 1{,}17$ MeV, $E_{\gamma2} = 1{,}33$ MeV).

L'utilisation du rayonnement ultraviolet convient parfaitement à la réticulation de films minces de ces résines. Pour des couches épaisses, l'utilisation de faisceaux d'électrons ou de rayonnements ionisants ($\gamma$, X) est souhaitable car ils sont plus pénétrants.

Dans le cas de la microlithographie l'irradiation, sauf pour le masquage électronique a lieu à travers un masque plaqué contre l'objet à traiter et capable d'arrêter le rayonnement.

Enfin, lorsqu'on doit développer le masque de résine, on dissout les zones de résine non irradiée à l'aide d'une cétone, par exemple de la méthyl-4 pentanone -2.

A titre d'exemple d'application de la résine selon l'invention, on donne ci-après le mode opératoire d'une microlithographie sur un substrat de silicium recouvert de $SiO_2$ pour réalisation collective de circuits à semiconducteurs.

On a choisi le cas d'une résine constituée par un copolymère de méthacrylate de 3-thiétanyle et de méthacrylate de méthyle, l'étalement de la couche par centrifugation et l'irradiation par les rayons X.

On procédé d'abord à la dissolution du copolymère dans la méthyl-4 pentanone -2 de façon à obtenir une solution à 10% en poids de copolymère.

La centrifugation avec une vitesse de rotation de 5000 tours/minute permet d'obtenir une couche de 0,5 à 1 micron d'épaisseur.

Un traitement thermique à 180°C pendant une demi-heure permet l'élimination du solvant résiduel.

Après plaquage sur l'échantillon à irradier d'un masque, on irradie par des rayons X de 8,34 angströms de longueur d'onde (obtenus avec une anticathode d'aluminium). La durée d'irradiation est de l'ordre de quelques dizaines de minutes.

Le développement est effectué en plongeant l'échantillon dans un mélange constitué de 1,5 parties en volume de méthyl-4 pentanone-2 et de 1 partie de méthanol pendant 1 mn à 30°C.

**Revendications**

1. Résine réticulable par irradiation électronique ou photonique, caractérisée en ce qu'elle comporte au moins un polymère comprenant un cycle thiétane chimiquement lié audit polymère:

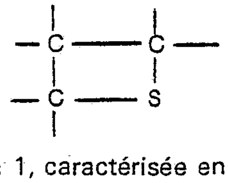

2. Résine suivant la revendication 1, caractérisée en ce que ledit polymère est un polymère d'un ester méthacrylique de formule:

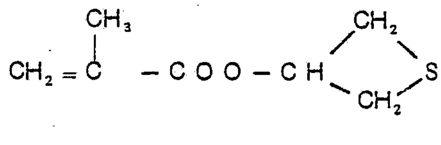

3. Résine suivant la revendication 1, caractérisée en ce que ledit polymère est un polymère d'un ester méthacrylique de formule générale:

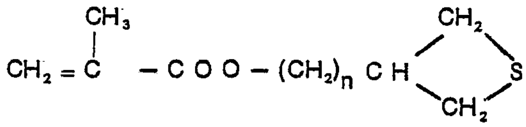

où n est entier de 1 à 10.

4. Résine suivant l'une des revendications 2 et 3, caractérisée en ce que le polymère est un copolymère d'un premier monomère contenant le cycle thiétane selon l'une des revendications 2 et 3 et d'un deuxième monomère de formule générale:

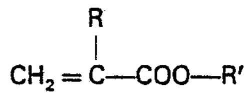

où R représente soit l'hydrogène, soit un groupement alkyle à m atomes de carbone (m étant un entier de 1 à 10), et où R' représente soit un groupement alkyle soit un groupement contenant au moins un cycle époxy, oxétane ou thiirane.

5. Résine suivant la revendication 4, caractérisée en ce que le deuxième monomère est le méthacrylate de méthyle.

6. Résine suivant la revendication 4, caractérisée en ce que le deuxième monomère est le méthacrylate de glycidyle.

7. Résine suivant la revendication 4, caractérisée en ce que le deuxième monomère est le méthacrylate d'épithio-2,3 propyle.

8. Résine suivant la revendication 4, caractérisée en ce que le deuxième monomère est le méthacrylate de butyle.

9. Résine suivant la revendication 4, caractérisée en ce que le deuxième monomère est l'acrylate d'éthyle.

10. Résine suivant l'une des revendications précédentes, caractérisée en ce qu'elle contient un agent photosensibilisateur.

11. Résine suivant la revendication 10, caractérisée en ce que le photosensibilisateur est un sel d'aryldiazonium de formule générale:

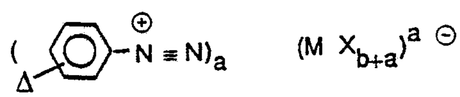

dans laquelle a et b désignent des entiers de 1 à 5, et Δ désigne un radical ou une pluralité de radicaux appartenant au groupe ci-après:

OH; $—NH_2$; $—N(CH_3)_2$; $—N(C_2H_5)_2$; —CHO; $—OCH_3$; $—NO_2$; 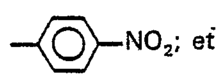 et 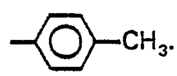

M désignant un élément appartenant au groupe d'éléments ci-après: Fe, Sn, Sb, Bi, B, P, As; et X désignant un halogène tel que F ou Cl.

12. Résine suivant la revendication 10, caractérisée en ce que le photosensibilisateur est un sel d'aryliodonium de formule générale:

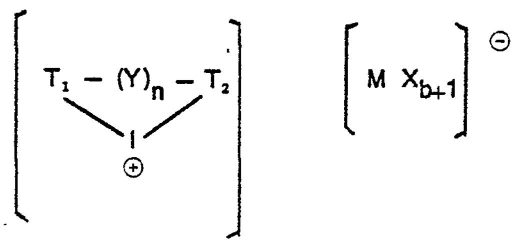

(où n = 0 ou 1) ou un sel de triarylsufonium:

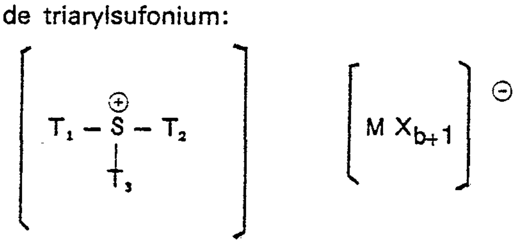

avec les conventions suivantes:

—$T_1$, $T_2$ et $T_3$ désignent des radicaux aromatiques, pouvant être identiques, comprenant de 4 à 20 atomes de carbone, tels que: phényle, thiényle, furannyle et pyrazolyle;

—Y désigne un radical tel que:

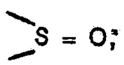 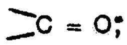 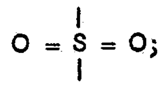 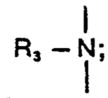

où $R_3$ est un atome d'hydrogène, un alkyle ou un acyle;

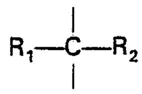

où $R_1$ et $R_2$ désignent des radicaux, pouvant être identiques, tels que H ou un alkyle de 1 à 4 atomes de carbone, ou un alkényle de 2 à 4 atomes de carbone;

—M désigne l'un des éléments suivants:

Fe, Sn, Sb, Bi, B, P, As;

—X désigne un halogène tel que F ou Cl;

—b désigne un entier de 1 à 5.

13. Utilisation d'une résine suivant l'une des revendications précédentes dans la préparation de masques destinés à la fabrication de composants électroniques.

14. Utilisation d'une résine suivant l'une des revendications 1 à 11, pour la formation de couches protectrices d'objet industriels.

15. Utilisation selon l'une des rev. 13 ou 14, caractérisée en ce que la résine est appliquée à l'état dissous dans la méthyl-4 pentanone-2.

## Claims

1. By electronic or photonic irradiation cross-linkable resin, characterized in that it presents at least one polymer comprising a thietane ring chemically bound to said polymer:

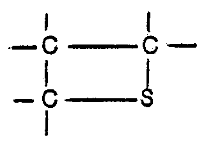

2. Resin according to claim 1 characterized in that said polymer is a polymer of a methacrylic ester of the formula:

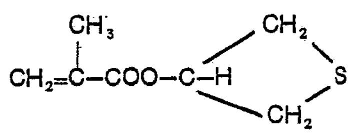

3. Resin according to claim 1 characterized in that said polymer is a polymer of a methacrylic ester of the general formula:

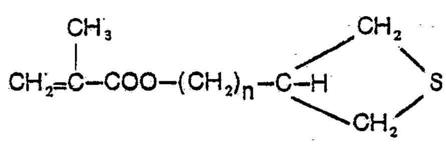

wherein n is an integer from 1 to 10.

4. Resin according to one of the claims 2 and 3 characterized in that the polymer is a copolymer of a first monomer containing the thietane ring according to one of the claims 2 and 3 and of a second monomer of the general formula:

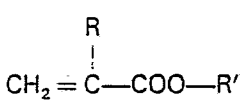

wherein R represents either hydrogen or an alkyl group with m carbon atoms (m being an integer from 1 to 10), and wherein R' represents either an alkyl group or a group containing at least one epoxy-, oxetane or thiirane ring.

5. Resin according to claim 4 characterized in that the second monomer is methyl methacrylate.

6. Resin according to claim 4 characterized in that the second monomer is glycidyl methacrylate.

7. Resin according to claim 4 characterized in that the second monomer is 2,3-epithiopropyl methacrylate.

8. Resin according to claim 4 characterized in that the second monomer is butyl methacrylate.

9. Resin according to claim 4 characterized in that the second monomer is ethyl acrylate.

10. Resin according to one of the foregoing claims characterized in that it contains a photosensitizing agent.

11. Resin according to claim 10 characterized in that the photosensitizer is an aryldiazonium salt of the general formula:

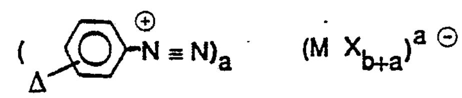

wherein a and b signify integers from 1 to 5, and Δ signifies a residue or a plurality of residues belonging to the following group:

—OH; —$NH_2$; —$N(CH_2)_2$; —$N(C_2H_5)_2$; —CHO; —$OCH_3$; —$NO_2$; 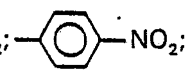 and 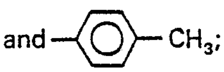

wherein M signifies an element belonging to the following group of elements: Fe, Sn, Sb, Bi, B, P, As; and wherein X signifies a halogen such as F or Cl.

12. Resin according to claim 10 characterized in that the photosensitizer is an aryliodonium salt of the general formula:

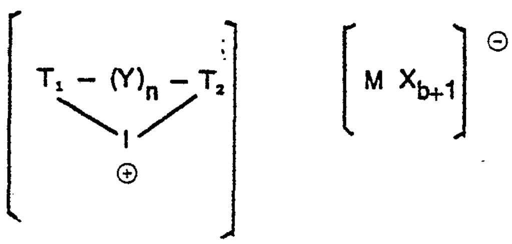

(wherein n = 0 or 1) or a triarylsulfonium salt:

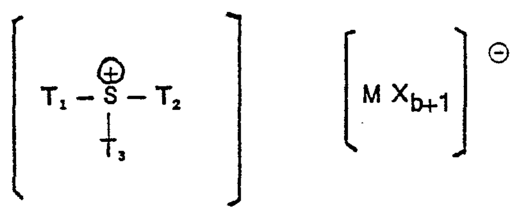

with the following terms:

—$T_1$, $T_2$ and $T_3$ signify aromatic residues which may be identical, comprising from 4 to 20 carbon atoms such as: phenyl, thienyl, furanyl and pyrazolyl;

—Y signifies a residue such as:

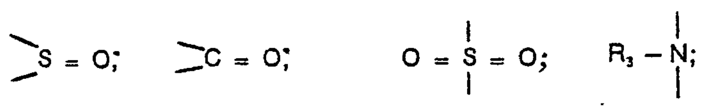

wherein $R_3$ is a hydrogen atom, an alkyl or an acyl;

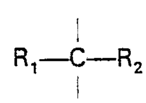

wherein $R_1$ and $R_2$ signify residues which may be identical, such as H or an alkyl from 1 to 4 carbon atoms, or an alkenyl from 2 to 4 carbon atoms;

—M signifies one of the following elements: Fe, Sn, Sb, Bi, B, P, As;

—X signifies a halogen such as F or Cl;

—b signifies an integer from 1 to 5.

13. Use of a resin according to one of the foregoing claims within the preparation of masks destined for the fabrication of electronic components.

14. Use of a resin according to one of the claims 1 to 11 for the formation of protective layers of industrial articles.

15. Use according to one of claims 13 or 14 characterized in that the resin is applied in a state dissolved in 4-methyl pentanone-2.

**Patentansprüche**

1. Durch Elektronen- oder Photonenbestrahlung vernetzbares Harz, dadurch gekennzeichnet, daß es mindestens ein Polymer aufweist, welches einen an dieses Polymer chemisch gebundenen Thietan-Ring umfaßt:

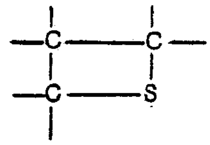

2. Harz nach Anspruch 1, dadurch gekennzeichnet, daß das Polymer ein Polymer eines Methacrylesters der Formel:

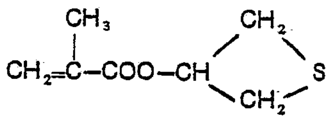

ist.

3. Harz nach Anspruch 1, dadurch gekennzeichnet, daß das Polymer ein Polymer eines Metharylesters der allgemeinen Formel:

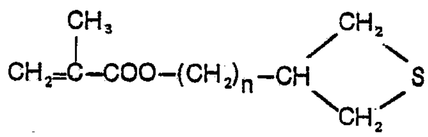

ist, worin n eine ganze Zahl zwischen 1 und 10 ist.

4. Harz nach einem der Ansprüche 2 oder 3, dadurch gekennzeichnet, daß das Polymer ein Copolymer aus einem ersten Monomer, das den Theitan-Ring gemäß einem der Ansprüche 2 oder 3 enthält, und aus einem zweiten Monomer der allgemeinen Formel:

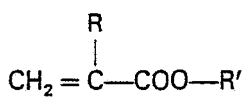

ist, worin R entweder ein Wasserstoffatom oder eine Alkylgruppe mit m Kohlenstoffatomen ist (wobei m eine ganze Zahl zwischen 1 und 10 bedeutet) und worin R′ entweder eine Alkylgruppe oder einen mindestens einen Epoxy-, Oxetan- oder Thiiran-Ring enthaltenden Rest darstellt.

5. Harz nach Anspruch 4, dadurch gekennzeichnet, daß das zweite Monomer Methylmethacrylat ist.

6. Harz nach Anspruch 4, dadurch gekennzeichnet, daß das zweite Monomer Glycidylmethacrylat ist.

7. Harz nach Anspruch 4, dadurch gekennzeichnet, daß das zweite Monomer 2,3-Epithio-propylmethacrylat ist.

8. Harz nach Anspruch 4, dadurch gekennzeichnet, daß das zweite Monomer But-ylmethacrylat ist.

9. Harz nach Anspruch 4, dadurch gekennzeichnet, daß das zweite Monomer Äthylacrylat ist.

10. Harz nach einem der vorhergehenden Ansprüche, dadurch gekennzeichnet, daß es ein photosensibilisierendes Mittel enthält.

11. Harz nach Anspruch 10, dadurch gekennzeichnet, daß der Photosensibilisator ein Aryldiazoniumsalz der allgemeinen Formel:

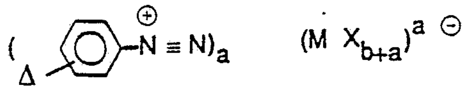

ist, worin a und b jeweils ganze Zahlen zwischen 1 und 5 bedeuten und worin Δ einen oder mehrere, zu der nachstehend aufgeführten Gruppe gehörende(n) Rest(e) bedeutet:

$—OH$; $—NH_2$; $—N(CH_2)_2$; $—N(C_2H_5)_2$; $—CHO$; $—OCH_3$; $—NO_2$; 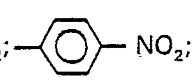 und 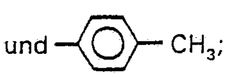

und worin M ein zur Gruppe der folgenden Elemente gehörendes Element bedeutet: Fe, Sn, Sb, Bi, B, P, As; und worin X ein Halogen wie F oder Cl bedeutet.

12. Harz nach Anspruch 10, dadurch gekennzeichnet, daß der Photosensibilisator ein Aryliodoniumsalz der allgemeinen Formel:

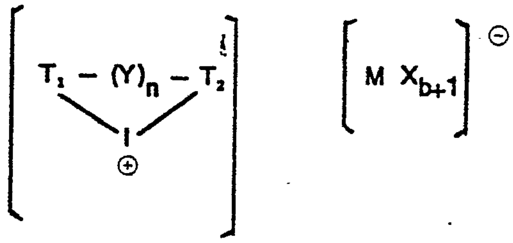

(worin n = 0 oder 1 ist) oder ein Triarylsulfoniumsalz:

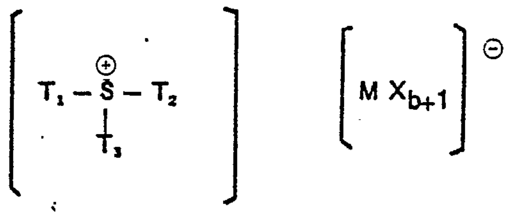

mit den folgenden Bedingungen ist:

— $T_1$, $T_2$ und $T_3$ benzeichnen aromatische Reste, die gleich sein können und 4 bis 20 Kohlenstoffatome umfassen, wie Phenyl, Thienyl, Furanyl und Pyrazolyl;

—Y bezeichnet einen Rest wie:

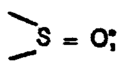 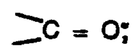 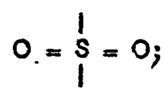 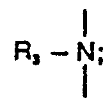

worin $R_3$ ein Wasserstoffatom, ein Alkyl- oder Acyl-Rest ist,

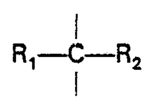

worin $R_1$ und $R_2$ Reste, die gleich sein können, wie H oder einen Alkylrest mit 1 bis 4 Kohlenstoffatomen oder einen Alkenylrest mit 2 bis 4 Kohlenstoffatomen bezeichnen;

—M eines der folgenden Elemente bezeichnet: Fe, Sn, Sb, Bi, B, P, As;

—X ein Halogen wie F oder Cl bezeichnet;

—b eine ganze Zahl zwischen 1 und 5 bezeichnet.

13. Verwendung eines Harzes gemäß einem der vorhergehenden Ansprüche bei der Herstellung von für die Erzeugung elektronischer Bauteile bestimmten Masken.

14. Verwendung eines Harzes gemäß einem der Ansprüche 1 bis 11 zur Herstellung von Schutzüberzügen für gewerbliche Erzeugnisse.

15. Verwendung nach einem der Ansprüche 13 oder 14, dadurch gekennzeichnet, daß das Harz in in 4-Methylpentan-2-on gelöstem Zustand verwendet wird.